# EUROPÄISCHE PATENTANMELDUNG

(11) **EP 1 396 937 A2**
(43) Veröffentlichungstag der Anmeldung: **10.03.2004**
(21) Anmeldenummer: 03017857.8
(22) Anmeldetag: 05.08.2003
(51) Int. Cl.: H03K 17/06

(54) **Betriebsschaltung mit verbesserter Leistungsversorgung einer Treiberschaltung**

(30) Priorität: 04.09.2002 DE 10241304
(71) Anmelder: Patent-Treuhand-Gesellschaft für elektrische Glühlampen mbH, 81543 München (DE)
(72) Erfinder: Limmer, Walter, 80337 München (DE)

(57) **Zusammenfassung**

Die Erfindung betrifft die Leistungsversorgung einer Treiberschaltung (V) eines Schalttransistors (T) in einer Betriebsschaltung insbesondere für Lampen. Die Versorgung erfolgt über eine Pumpschaltung mit einem Potentialtrennungskondensator (C₂), zwei Gleichrichterdioden (D₁, D₂) und einem Speicherkondensator (C₁) und ist unabhängig von dem Bezugspotential des Schalttransistors (T).

## Beschreibung

### Technisches Gebiet

Die Erfindung bezieht sich auf eine Betriebsschaltung für eine Last, die einen von einer Treiberschaltung angesteuerten Schalttransistor enthält.

Die Erfindung richtet sich daher insbesondere, jedoch nicht ausschließlich, auf eine Betriebsschaltung für Lampen.

### Stand der Technik

Betriebsschaltungen enthalten in der Regel zumindest einen Schalttransistor, der beispielsweise bei einem Wechselrichter einen lastseitigen Anschluss taktweise mit einem Versorgungspotential verbindet. Der Schalttransistor muss dementsprechend angesteuert werden, also mit Rücksicht auf seine Funktion mit geeigneten Potentialen an seinem Steueranschluss versorgt werden. Dies gilt allgemein auch für sogenannte stromgesteuerte Schalttransistoren wie Bipolartransistoren.

Zur Ansteuerung des Schalttransistors wird ein Schaltungsteil verwendet, der im allgemeinen als Treiberschaltung bezeichnet wird. Dieser Begriff wird im Folgenden für jedweden Typ von Ansteuerung des Schalttransistors gebraucht, ohne einschränkt gemeint zu sein.

Die Treiberschaltung selbst benötigt wiederum entsprechende Versorgungspotentiale. Häufig wird hier ein Speicherkondensator zur Speicherung elektrischer Energie zum Betrieb der Treiberschaltung eingesetzt. Dieser Speicherkondensator muss daher mit geeigneten Potentialen versorgt werden.

Je nach den Umständen der Verschaltung des Schalttransistors kann es dabei zu Problemen mit der Bereitstellung der Versorgungspotentiale für die Treiberschaltung bzw. deren Speicherkondensator kommen. Dies gilt insbesondere bei sogenannten hochliegenden Schalttransistoren, deren einer Anschluss an dem Versorgungspotential der Betriebsschaltung und deren anderer Anschluss lastseitig angeschlossen ist. (Hier geht es um eine sogenannte "high-side"-Treiberschaltung.) Mit "lastseitig" ist dabei auch ein mittelbarer Anschluss an der Last z.B. über zwischengeschaltete Drosseln, Dioden und dgl. gemeint.

### Darstellung der Erfindung

Der Erfindung liegt das technische Problem zugrunde, eine Betriebsschaltung zum Betreiben einer Last mit einem hochliegenden Schalttransistor anzugeben, bei der eine Treiberschaltung mit einer verbesserten Versorgung verwendet wird.

Die Erfindung richtet sich hierzu auf eine Schaltung zum Betreiben einer Last mit einem Schalttransistor, der einerseits an einem Versorgungspotential und andererseits (im obigen Sinn) lastseitig angeschlossen ist und dessen Steueranschluss zumindest zeitweise außerhalb des Potentialbereichs zwischen dem Versorgungspotential und dem Potential des lastseitigen Anschlusses des Schalttransistors anzusteuern ist, welche Schaltung ferner eine Treiberschaltung zum Ansteuern des Steueranschlusses und einen Speicherkondensator zum Versorgen der Treiberschaltung mit einer Versorgungsleistung aufweist; gekennzeichnet durch eine Pumpschaltung zum Aufladen des Speicherkondensators aus einem von dem Potential des lastseitigen Anschlusses unabhängigen Versorgungswechselpotential mit einer die Anschlüsse des Speicherkondensators verbindenden Reihenschaltung zweier gleichgerichteter Gleichrichterdioden und einem mit einem Abgriff zwischen den Gleichrichterdioden einerseits und dem Versorgungswechselpotential andererseits verbundenen Potentialtrennungskondensator.

Die Grundidee der Erfindung besteht damit in einer Versorgung des Speicherkondensators durch ein Versorgungswechselpotential, das von dem lastseitigen Anschluss des Schalttransistors potentialmäßig völlig unabhängig gehalten werden kann. Dazu wird in der Pumpschaltung ein Potentialtrennungskondensator verwendet. Über diesen Potentialtrennungskondensator wird das Versorgungswechselpotential an einen Mittenabgriff zwischen zwei gleichgerichtet in Serie geschalteten Gleichrichterdioden gekoppelt, die somit einen zwischen die zu dem Mittenabgriff entgegengesetzten Anschlüsse der Gleichrichterdioden geschalteten Speicherkondensator gleichsinnig auflädt. Dabei kann der Speicherkondensator potentialmäßig auf ein für die Treiberschaltung günstiges Bezugspotential bezogen sein, insbesondere also auch auf ein im Betrieb der Betriebsschaltung schwankendes Potential. Wenn also beispielsweise ein FET (Feldeffekttransistor) als hochliegender Schalttransistor verwendet wird, dessen Source-Anschluss lastseitig verschaltet ist, so kann die Treiberschaltung durch die Pumpschaltung mit einem Versorgungswechselpotential betrieben werden, das potentialmäßig von dem Source-Potential des Schalttransistors unabhängig ist.

Da beispielsweise bei Wechselrichtern der lastseitige Anschluss des Schalttransistors zwischen einem (internen) Massepotential und dem Versorgungspotential des Wechselrichters schwankt, kann somit selbst in Schaltzuständen, in denen der lastseitige Anschluss im wesentlichen auf dem Versorgungspotential liegt, mit einem üblichen Versorgungspotential über die Pumpschaltung die Treiberschaltung versorgt werden. Dieses Versorgungspotential für die Treiberschaltung kann beispielsweise das für andere Treiberschaltungen oder Logikschaltungen in der Betriebsschaltung und deren Schaltungsumgebung verwendete Potential sein und namentlich im Betrag deutlich kleiner (also massenäher) als das Versorgungspotential des Wechselrichters sein. Die Pumpschaltung bietet also eine potentialmäßig besonders einfache und, auch zeitlich, unabhängig von der jeweiligen Betriebsphase der Betriebsschaltung betreibbare Möglichkeit zur Versorgung des Speicherkondensators.

Damit entfällt insbesondere die aus dem Stand der Technik bekannte Notwendigkeit, für das Aufladen des Speicherkondensators ganz bestimmte Betriebsphasen mit günstigen Potentialverhältnissen zu nutzen. Zur näheren Verdeutlichung wird auf das Ausführungsbeispiel verwiesen. Dennoch kann die Erfindung natürlich eventuell aus anderen Gründen in einer bestimmten Weise auf den Betrieb der Betriebsschaltung zeitlich abgestimmt verwendet werden.

Ein bevorzugter Anwendungsfall der Erfindung liegt bei Schalttransistoren mit einem FET-Eingang, also eigentlichen FET, insbesondere MOS-FET, oder bei sogenannten IGBT (Insulated Gate Bipolar Transistor). Diese benötigen im Unterschied zu reinen Bipolartransistoren im Vergleich zum Bezugspotential des Transistors relativ große Spannungen, um durchgeschaltet zu werden.

Zwischen dem Potentialtrennungskondensator und seiner Versorgungswechselspannung kann ein hier als erster Widerstand bezeichneter Schutzwiderstand vorgesehen sein. Dieser kann insbesondere dazu dienen, den Ausgang, der die Versorgungswechselspannung zur Verfügung stellt, beispielsweise ein MOS-FET-Gatter, vor größeren Strömen zu schützen, die auftreten können, wenn sich das Bezugspotential des Schalttransistors, also insbesondere der lastseitige Anschluss, schnell im Potential verändert und sich dieser Potentialsprung über den Potentialtrennungskondensator an dem Ausgang als Stromstoß bemerkbar macht. Der Schutzwiderstand dämpft solche Stromstöße infolge der zusammen mit dem Potentialtrennungskondensator gebildeten RC-Konstante ab.

Ferner ist vorzugsweise eine Potentialklemmung zwischen der genannten Versorgungswechselspannung und dem Potentialtrennungskondensator vorgesehen, um eine Impedanzentkopplung vornehmen zu können. Hierfür kommen zum Einen zwei gleichgerichtet in Serie geschaltete Gleichrichterdioden in Betracht, deren Mittenabgriff zwischen dem Versorgungswechselpotential und dem Potentialtrennungskondensator liegt, wobei zwischen dem Mittenabgriff und dem Versorgungswechselpotential ein hier als zweiter Widerstand bezeichneter Widerstand vorgesehen ist. Dabei kann übrigens auch zwischen dem Mittenabgriff und dem Potentialtrennungskondensator ein weiterer Schutzwiderstand vorgesehen sein. Zum Anderen kommt auch eine Schaltung mit einer Z-Diode (Zener-Diode) in Frage, die einen Leitungspunkt zwischen einem Versorgungswechselpotential-seitigen Widerstand (der sog. zweite Widerstand) und dem Potentialtrennungskondensator klemmt. Auch hier können weitere Schutzwiderstände zwischen dem geklemmten Punkt und dem Potentialtrennungskondensator vorgesehen sein.

Das Versorgungswechselpotential kann in unterschiedlichster Weise gewonnen werden. In vielen Fällen ist ein solches Versorgungswechselpotential ohnehin schon vorhanden oder kann durch ein brachliegendes Gatter mit nur geringem Aufwand erzeugt werden. Es können beispielsweise auch Ansteuerungspotentiale für andere Schalttransistoren, etwa in einem Hochsetzsteller, Verwendung finden.

Wenn das Versorgungswechselpotential für die Pumpschaltung relativ groß ist, kann es sinnvoll sein, den Speicherkondensator durch ein spannungsbegrenzendes Element zu schützen. Insbesondere kann es sich dabei um eine parallel zu dem Speicherkondensator und damit zu der Reihenschaltung der Gleichrichterdioden liegende Z-Diode handeln. Allerdings sollte das Versorgungswechselpotential nicht so groß sein, dass in störendem Umfang Verlustleistung in einer solchen Z-Diode erzeugt wird. Zur Veranschaulichung wird auf das Ausführungsbeispiel verwiesen.

Allgemein richtet sich die Erfindung auch auf Betriebsschaltungen für beliebige Lasten, insbesondere jedoch auf Lampenbetriebsschaltungen, also elektronische Vorschaltgeräte für Lampen. Dabei sind verschiedene Lampentypen relevant. Zum Einen kann es sich um elektronische Vorschaltgeräte beispielsweise für Halogenglühlampen handeln. Besonders bevorzugt sind jedoch Vorschaltgeräte für Gasentladungslampen. Dabei kommen zum einen Wechselrichter für Niederdruckgasentladungslampen in Betracht.

Zum zweiten richtet sich die Erfindung aber besonders auf Vorschaltgeräte für Hochdruckentladungslampen. Bei Letzteren treten sogenannte hochliegende Schalttransistoren beispielsweise in Vollbrückenschaltungen auf, die die Hochdruckentladungslampe enthalten und ein weitgehend konstantes Versorgungspotential für die Lampe taktweise mit unterschiedlicher Polarität an die Lampe legen. Damit sollen durch einen unidirektionalen Betrieb auftretende Probleme wie Farbverschiebungen, ungleichmäßiger Elektrodenabbrand und Ähnliches vermieden werden. Zum Zweiten treten bei Vorschaltgeräten für Hochdruckentladungslampen häufig jedoch auch Tiefsetzsteller oder andere Oszillatoren zur Erzeugung einer für eine Lampendrossel erforderlichen Wechselspannungsleistung auf, die ebenfalls hochliegende Transistoren enthalten.

Beide Anwendungen können in Vorschaltgeräten für Hochdruckentladungslampen auch kombiniert miteinander auftreten.

### Kurze Beschreibung der Zeichnungen

Im Folgenden soll die Erfindung anhand einer konkreten Darstellung eines Beispiels für den Stand der Technik und anhand zweier Ausführungsbeispiele mit verschiedenen Varianten näher veranschaulicht werden. Dabei offenbarte Einzelmerkmale können auch in anderen Kombinationen erfindungswesentlich sein.
- Fig. 1: zeigt eine schematisierte Darstellung einer an sich konventionellen Wechselrichterschaltung mit einer Halbbrücke.
- Fig. 2: zeigt eine schematisierte Darstellung einer an sich konventionellen Betriebsschaltung mit einem Tiefsetzsteller und einer Vollbrücke.
- Fig. 3: zeigt eine schematisierte Darstellung einer konventionellen Treiberschaltung für einen Schalttransistor aus Fig. 2.
- Fig. 4: zeigt eine erfindungsgemäße Treiberschaltung für den Schalttransistor aus den Fig. 2 und 3.
- Fig. 5: zeigt eine Variante einer erfindungsgemäßen Potentialklemmung für die Schaltung aus Fig. 4.
- Fig. 6: zeigt eine zweite Variante für eine erfindungsgemäße Potentialklemmung für die Schaltung aus Fig. 4.

### Bevorzugte Ausführung der Erfindung

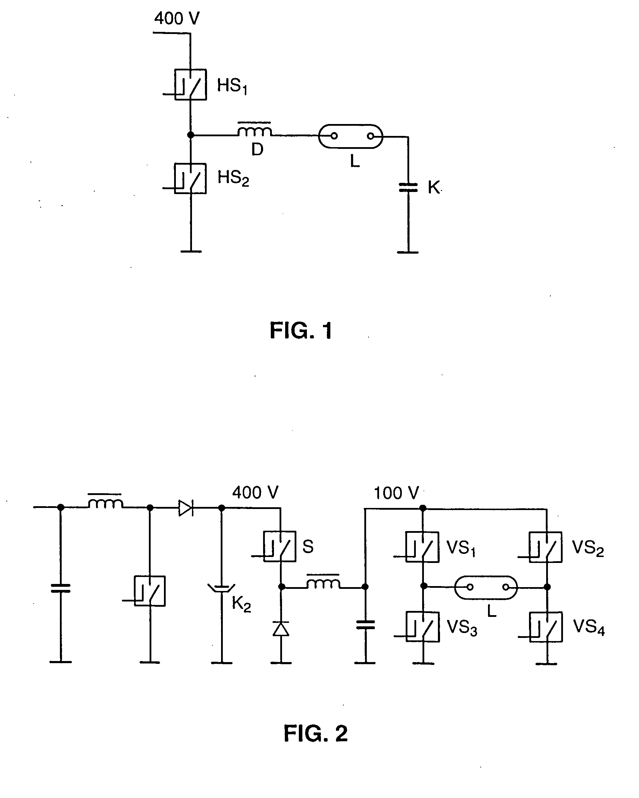

Fig. 1 zeigt ein erstes Beispiel für eine Betriebsschaltung für eine Lampe L, und zwar eine Halbbrückenschaltung mit zwei Schalttransistoren HS₁ und HS₂. In Verbindung mit einer noch zu erläuternden Treiberschaltung für den Schalttransistor HS₁ bildet eine Schaltung gemäß Fig. 1 jedoch ein Ausführungsbeispiel der Erfindung. In dieser Schaltung liegt der Schalttransistor HS₁ im Sinn der Erfindung "hoch"; er ist nämlich zwischen ein Versorgungspotential von beispielsweise 400 V und einen Mittenabgriff der Halbbrücke geschaltet. Der Mittenabgriff ist über eine übliche Lampendrossel D an die Last, nämlich eine Entladungslampe L geschaltet. Die Last ist wiederum über einen Kondensator K mit der geräteinternen Masse verbunden. Bei der Entladungslampe L kann es sich insbesondere um eine Niederdruckentladungslampe handeln, bei denen nach diesem Prinzip aufgebaute elektronische Vorschaltgeräte üblich sind. Die Funktionen der Lampendrossel D des Kondensators K sind allgemein bekannt und müssen hier nicht im Einzelnen erläutert werden. Überhaupt ist die Schaltung stark vereinfacht und dient lediglich dazu, die Positionen des für die Erfindung wesentlichen Schalttransistors HS₁ zu verdeutlichen. Demgegenüber liegt nämlich der zweite Schalttransistor HS₂ im Sinn der Erfindung "tief", er verbindet dabei die geräteinterne Masse mit dem lastseitigen Mittenabgriff.

Im Betrieb wird das Potential dieses Mittenabgriffs durch einen alternierenden Schaltbetrieb der Schalttransistoren HS₁ und HS₂ zwischen dem Versorgungspotential von hier 400 V und Masse hin- und hergeschaltet, woraus sich mit der entsprechenden Betriebsfrequenz von typischerweise 25 bis 50 kHz die Versorgungsleistung für die Entladungslampe L ergibt.

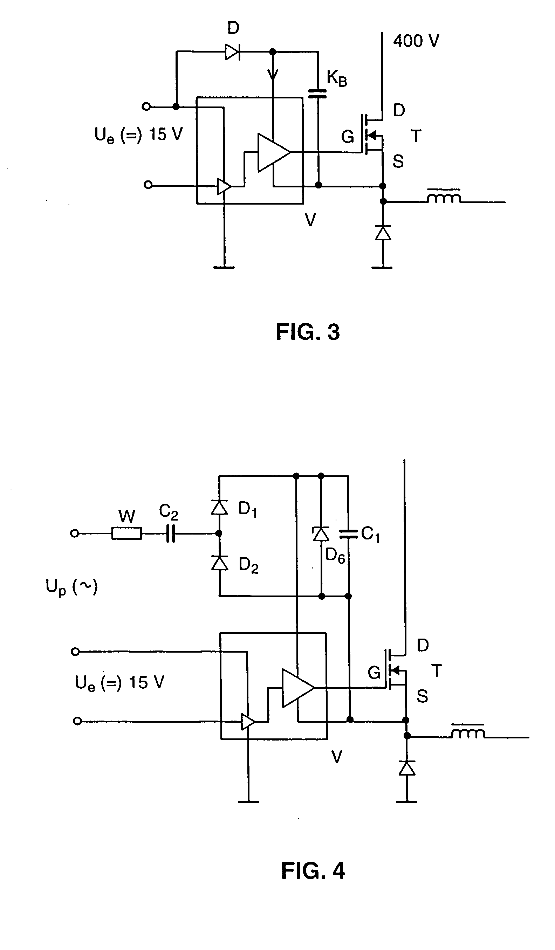

Wesentlich ist, dass der Schalttransistor HS₁ an seinem Steueranschluss, also insbesondere an der Gate-Elektrode der hier bevorzugten MOS-FET-Transistoren, zum sicheren Durchschalten eine Spannung in einer Größenordnung von z.B. etwa 10 V bezogen auf die lastseitige Source-Elektrode benötigt. Dies ist Aufgabe einer Treiberschaltung, die - in konventioneller Ausführung - in Fig. 3 näher dargestellt ist. Durch entsprechende Treiberschaltungen angesteuerte Schalttransistoren in Betriebsschaltungen werden als fremdgesteuerte Schalttransistoren bezeichnet. Es handelt sich dementsprechend um fremdgesteuerte Wechselrichter bzw. Oszillatoren.

Zunächst muss man sich in Fig. 3 die rechts unten eingezeichnete Diode durch den unteren Schalttransistor HS₂ aus Fig. 1 ersetzt denken; der eingezeichnete Schalttransistor T entspricht also dem Transistor HS₁ aus Fig. 1. Zwischen seinem Gate-Anschluss G und seinem Source-Anschluss muss die erwähnte Ansteuerspannung erzeugt werden. Dazu wird eine mit V bezeichnete Treiberschaltung verwendet, die einen in dem Kästchen V rechts eingezeichneten Verstärker enthält. Die Versorgung dieses Verstärkers ist auf das Potential des Source-Anschlusses des Schalttransistors T bezogen und wird durch einen Speicherkondensator K_{B} zur Verfügung gestellt. Der in Fig. 3 dargestellte Speicherkondensator K_{B} wird gelegentlich als sogenannter Bootstrap-Kondensator bezeichnet. Dieser Speicherkondensator muss mit der entsprechenden Spannung aufgeladen werden. Dazu wird eine ohnehin zur Versorgung verschiedener Logikschaltungen in der Betriebsschaltung vorgesehene Versorgungsgleichspannung Uₑ von etwa 15 V verwendet. Diese ist jedoch auf die geräteinterne Masse bezogen. Eine ausreichende Spannung steht also nur zur Verfügung, wenn der untere Schaltransistor HS₂ geschlossen ist und damit der Source-Anschluss des oberen Schalttransistors HS₁ im Wesentlichen auf der geräteinternen Masse liegt. Zu dieser Zeit wird der Speicherkondensator K_{B} über die Diode D aus der Versorgungsgleichspannung Uₑ aufgeladen. Wenn das Potential des Source-Anschlusses des Schalttransistors HS₁ bzw. T nach dem öffnen des unteren Schalttransistors HS₂ und dem Schließen des oberen Schalttransistors HS₁ bzw. T im Wesentlichen auf das Versorgungspotential 400 V ansteigt, wird durch die Potentialtrennung der nun sperrenden Diode D die Spannung an dem in Fig. 3 oberen Anschluss des Speicherkondensators K_{B} mit verschoben, so dass die für die Treiberschaltung V benötigte Versorgungsspannung trotz der Potentialverschiebung an dem Source-Anschluss nach wie vor zur Verfügung steht. Allerdings sind die Ladephasen aus den erwähnten Gründen begrenzt auf die Zeitpunkte mit geeignetem niedrigen Potential an dem Mittenabgriff. Je nach erwünschter Taktfrequenz des Schaltbetriebs der Schalttransistoren muss daher der Speicherkondensator K_{B} die für die Treiberschaltung benötigte Energie ausreichend lang speichern können.

Ein weiteres konventionelles Schaltdiagramm zeigt Fig. 2. Hier handelt es sich um die schematisierte Betriebsschaltung einer Hochdruckentladungslampe L, die in der in Fig. 2 rechts eingeschalteten Vollbrücke aus den Schalttransistoren VS₁ bis VS₄ verschaltet ist. Dabei werden die Schalttransistoren VS₁ und VS₄ einerseits und VS₂ und VS₃ andererseits gemeinsam geschaltet, so dass die an dem oben liegenden Zweig anliegende Spannung von etwa 100 V mit abwechselnder Polarität an die Hochdruckentladungslampe L angelegt werden kann. Dies ist bei Hochdrucklampen aus den bereits erwähnten Gründen sinnvoll. Die Schalttransistoren VS₁ und VS₃ einerseits und VS₂ und VS₄ andererseits bilden im Prinzip eine Halbbrücke gemäß Fig. 1.

Das Versorgungspotential von etwa 100 V für die Vollbrücke wird von einem in Fig. 2 nicht bezifferten Kondensator zur Verfügung gestellt. Dieser wird geladen über eine ebenfalls nicht bezifferte Lampendrossel, die ähnliche Funktionen wie die Lampendrossel D in Fig. 1 ausübt. Die Lampendrossel ist angeschlossen an den Mittenabgriff eines Tiefsetzstellers mit dem oberen Schalttransistor S und der unteren Diode, die auch in Fig. 3 eingezeichnet ist. Diese Diode steht an der Stelle des Schalttransistors HS₂ aus Fig. 1 und stellt einen Strom zur Verfügung, wenn der Schalttransistor S geöffnet ist. Das Schaltkonzept des Tiefsetzstellers ist an sich bekannt und wird hier nicht im Einzelnen erläutert. Er erzeugt aus einem Versorgungspotential von etwa 400 V, das dem entsprechenden Versorgungspotential aus Fig. 1 entspricht, ähnlich der Halbbrücke aus Fig. 1 eine Versorgungswechselspannung für die Vollbrücke und die Hochdruckentladungslampe L. Diese Versorgungswechselspannung mit der Tiefsetzstellerfrequenz ist für die Funktion der Lampendrossel notwendig, die auch hier wegen des negativen differentiellen Widerstands von Entladungslampen zur Kennlinienstabilisierung dient. Die durch den Tiefstellsetzer zur Verfügung gestellte Wechselspannung wird allerdings durch den bereits erwähnten Kondensator wieder geglättet, so dass an der Vollbrücke im Wesentlichen eine Gleichspannung anliegt. Wegen der Gefahr innerer Resonanzen ist die Betriebsfrequenz der Versorgung der Hochdruckentladungslampe L durch die Vollbrücke in der Regel nicht deutlich größer als 1 kHz, also deutlich kleiner als eine übliche Betriebsfrequenz der Halbbrücke aus Fig. 1.

Der Tiefsetzsteller in Fig. 2 mit dem Schalttransistor S wird wiederum mit einer im Wesentlichen konstanten Gleichspannung von etwa 400 V von einem Hochsetzsteller versorgt, der aus den in Fig. 2 links von dem Schalttransistor S eingezeichneten Bauteilen, nämlich der Drossel, der Diode, dem weiteren Schalttransistor und dem Elektrolytkondensator K₂, besteht. Der Hochsetzsteller ist eine Leistungsfaktorkorrekturschaltung und dient im Wesentlichen zur Erzeugung einer weitgehend konstanten Gleichspannung aus einer gleichgerichteten Netzwechselspannung bei gleichzeitig weitgehend sinusförmiger Stromaufnahme aus dem Netz. Davor ist eine nicht näher dargestellte Gleichrichter- und Filterschaltung geschaltet. Diese Schaltung einschließlich des Hochsetzstellers wird in der Praxis auch links in der von Fig. 1 eingezeichneten Halbbrücke in der gezeichneten oder ähnlicher Form vorliegen. Sie ist jedoch für die Erfindung ohne weiteren Belang.

Die Betriebsschaltung aus Fig. 2 zeigt einerseits mit dem Transistor S in einer zu dem Schalttransistor HS₁ aus Fig. 1 vergleichbaren Position einen weiteren hochliegenden Schalttransistor. Ferner sind allerdings auch die Schalttransistoren VS₁ und VS₂ aus der Vollbrücke im Sinn der Erfindung hochliegend, jedoch in Bezug auf ein anderes Versorgungspotential. Bei diesen drei Schalttransistoren S, VS₁, VS₂ könnte man sich jeweils die in Fig. 3 dargestellte Treiberschaltung vorstellen. Sinngemäß gelten die zuvor in Bezug auf den Transistor HS₁ getroffenen Feststellungen auch für diese drei Schalttransistoren.

Die erfindungsgemäße Lösung für die Versorgung der Treiberschaltung zeigt Fig. 4. Dabei wird von dem gleichen Schalttransistor T, der gleichen eigentlichen Treiberschaltung V (ohne Versorgung) und dem gleichen Versorgungspotential Uₑ wie in Fig. 3 ausgegangen. Dem Speicherkondensator K_{B} entspricht allerdings ein Speicherkondensator C₁, der abweichend bezeichnet ist, weil er erheblich kleiner dimensioniert sein kann als der Speicherkondensator K_{B}. Er wird geladen über eine seine beiden Anschlüsse verbindende Serienschaltung zweier Gleichrichterdioden D₁ und D₂, an deren Mittenabgriff ein Potentialtrennungskondensator C₂ angeschlossen ist. Der Potentialtrennungskondensator C₂ ist durch die beiden Dioden D₁ und D₂ mit einer jeweiligen Durchlassspannung von beispielsweise 0,7 V geklemmt, so dass sich Spannungspulse unter dieser positiven und negativen Durchlassspannung jeweils über die Dioden auf den Speicherkondensator C₁ entladen. Dessen anderer Anschluss ist über einen Schutzwiderstand W mit einem Versorgungswechselpotential Uₚ verbunden. Der Schutzwiderstand W entspricht dem sogenannten ersten Ohm'schen Widerstand. Insgesamt ist dadurch eine Pumpschaltung zum Aufladen des Speicherkondensators C₁ unabhängig von dem Potential des an dem unteren Anschluss des Speicherkondensators C₁ liegenden Source-Anschlusses gegeben. Die Pumpschaltung koppelt über den Potentialtrennungskondensator C₂ die Wechselspannung an den Speicherkondensator C₁. Die beiden Dioden D₁ und D₂ stellen dabei sicher, dass unabhängig von den jeweiligen Vorzeichen der eingekoppelten Wechselspannungspulse immer unipolar geladen wird. Da der Potentialtrennungskondensator C₂ eine reine Wechselspannungskopplung herstellt, dabei jedoch galvanisch trennt, ist der Speicherkondensator C₁ galvanisch nicht an das Versorgungswechselpotential Uₚ gekoppelt. Er kann also völlig unabhängig von dem Potentialzustand des Source-Anschlusses S und damit seines eigenen Potential beständig geladen werden. Somit ist es nicht mehr notwendig, sich auf günstige Schaltphasen der Betriebsschaltung zu beschränken. Damit kann aber auch der Speicherkondensator für erheblich kleinere Ladungen bzw. Speicherzeiten ausgelegt werden und damit kleiner und kostengünstiger ausgeführt sein.

Zum Schutz der Treiberschaltung V kann eine spannungsbegrenzende Z-Diode D₆ mit einer Durchbruchsspannung von z.B. 15 V vorgesehen sein. Damit kann als Versorgungswechselpotential Vₚ beispielsweise das Drainpotential des Hochsetztransistors aus Fig. 2 oder ein anderes an sich zu großes Potential verwendet werden, das nicht eigens erzeugt werden muss.

Weiterhin gewinnt man die Freiheit, den Schalttransistor T beliebig schnell zu schalten, ohne die Treiberschaltung V zu gefährden.

Ein besonderes Problem tritt bei Hochdruckentladungslampen auf, bei denen die in Fig. 2 verdeutlichte Vollbrücke in bestimmten Betriebszuständen der Hochdruckentladungslampe L auch mit relativ geringen Frequenzen arbeitet.

In solchen Betriebszuständen muss der Bootstrap-Kondensator K_{B} aus Fig. 3 die von der Treiberschaltung V benötigte Energie über eine komplette Periodenlänge speichern, was beispielsweise bei Zündvorgängen von Hochdruckentladungslampen und in sogenannten Gleichstromphasen beim Anlauf einer Hochdruckentladungslampe Zeiten in der Größenordnung von Sekunden entsprechen kann. Der Bootstrap-Kondensator K_{B} muss also eine ganz beträchtliche Kapazität in der Größenordnung von beispielsweise einigen 10 µF aufweisen. In Anbetracht der weiteren Anforderungen im Hinblick auf die Betriebstemperatur, die Lebensdauer und die Spannungsfestigkeit kann dies zu erheblichen Bauteilkosten führen. Ferner muss die Diode D eine Spannungsfestigkeit aufweisen, die für das Versorgungspotential von etwa 400 V in diesem Beispiel ausreicht.

Demgegenüber lässt sich in der Schaltung gemäß Fig. 4 ein relativ kleiner Speicherkondensator C₁ verwenden, weil dieser im Wesentlichen dauernd geladen werden kann. Auch unter Berücksichtigung der zusätzlichen Kosten für den Potentialtrennungskondensator C₂ ist diese Lösung erheblich günstiger.

Der sogenannte erste Ohm'sche Widerstand W in Fig. 4 schützt ein üblicherweise zur Bereitstellung des Versorgungswechselpotentials Uₚ verwendetes MOS-FET-Gatter oder eine andere Ausgangsstufe vor zu großen Stromstößen, die durch plötzliche Potentialänderungen am Source-Anschluss des Schalttransistors T über den Potentialtrennungskondensator C₂ eingekoppelt werden können. Um das Umschalten in dem Schalttransistor T nicht zu "hart" auszuführen, kann zwischen den Ausgang der Treiberschaltung W und den Gate-Anschluss des Transistors T ein in Fig. 4 nicht eingezeichneter Widerstand geschaltet sein, der gemeinsam mit der entsprechenden Transistorkapazität für etwas "weichere" Schaltflanken sorgt. Ferner kann zum Schutz der Treiberschaltung V zwischen dem Source-Anschluss des Schalttransistors T und dem daran angeschlossenen Versorgungsanschluss der Treiberschaltung V ein Schutzwiderstand geschaltet sein.

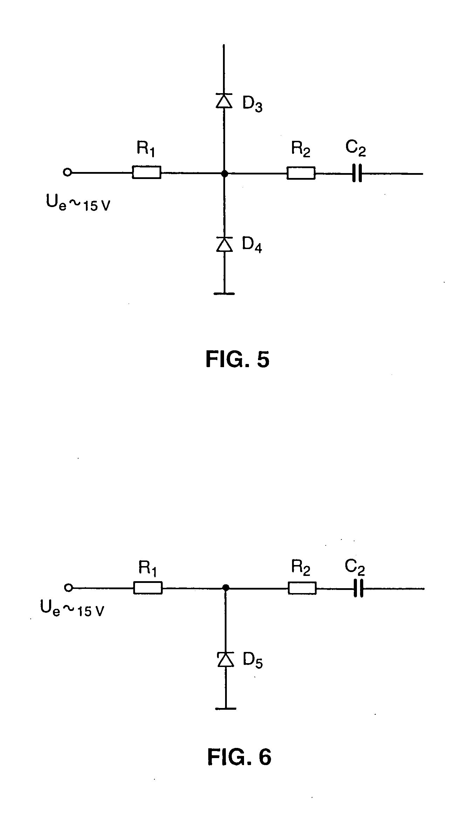

Für die Schaltungsstrecke zwischen dem Versorgungswechselpotential Uₚ und dem Potentialtrennungskondensator C₂ werden zwei weitere Varianten in den Fig. 5 und 6 dargestellt. Dabei handelt es sich um Schaltungsteile zur Potentialklemmung mit Klemmdioden. Die Variante aus Fig. 5 verwendet dazu zwei gleichsinnig in Serie geschaltete Gleichrichterdioden D₃ und D₄, deren Mittenabgriff jeweils über einen Widerstand R₁ bzw. R₂ mit dem Versorgungswechselpotential Uₚ bzw. dem Potentialtrennungskondensator C₂ verbunden ist. Unter Berücksichtigung der Durchlassspannung der Dioden D₃ und D₄ ist der Mittenabgriff damit auf ein Potential zwischen z.B. -0,7 und +15,7 V geklemmt. Der Widerstand R₁ dient dazu, dass die erwähnten Stromstöße über C₂ nicht an die das Versorgungswechselpotential Uₚ liefernde Ausgangsstufe sondern über die Dioden D₃ und D₄ abfließen. Der Widerstand R₂ bildet seinerseits eine Strombremse für die beiden Klemmdioden D₃ und D₄. Da in Folge der Potentialklemmung der Widerstandswert des Widerstands R1 deutlich kleiner als der des Widerstands W aus Fig. 4 sein kann, wird der durch das Versorgungswechselpotential Uₚ gelieferte Strom nicht übermäßig begrenzt.

Diese Schaltung kann vorteilhafterweise bereits Bestandteil des bereits erwähnten MOS-FET-Gatters sein.

Die zweite Variante zeigt Fig. 6. Hier ist anstelle der beiden Gleichrichterdioden D₂ und D₄ eine Z-Diode D₅ zur Potentialklemmung verwendet.

Die Variante mit den beiden Klemmdioden D₃ und D₄ aus Fig. 5 ist gegenüber der Variante der Fig. 6 deswegen bevorzugt, weil die grundsätzliche Möglichkeit besteht, den in Fig. 5 oberen Anschluss der Diode D₃ so zu verschalten, dass eine Energierückspeisung zurück in die Versorgungsgleichspannung Vₑ erfolgt. Im Gegensatz dazu wird der Stromstoß durch die Z-Diode D₅ grundsätzlich in Verlustleistung umgesetzt.

## Patentansprüche

1. Schaltung zum Betreiben einer Last (L)
mit einem Schalttransistor (HS₁, VS₁, VS₂, S, T), der einerseits an einem Versorgungspotential und andererseits lastseitig angeschlossen ist und dessen Steueranschluss (G) zumindest zeitweise außerhalb des Potentialbereichs zwischen dem Versorgungspotential und dem Potential des lastseitigen Anschlusses des Schalttransistors (HS₁, VS₂, VS₂, S, T) anzusteuern ist,
welche Schaltung ferner eine Treiberschaltung (V) zum Ansteuern des Steueranschlusses (G) und einen Speicherkondensator (C₁) zum Versorgen der Treiberschaltung (V) mit einer Versorgungsleistung aufweist;
**gekennzeichnet durch** eine Pumpschaltung (W, C₂, D₁, D₂) zum Aufladen des Speicherkondensators (C₁) aus einem von dem Potential des lastseitigen Anschlusses unabhängigen Versorgungswechselpotential (Uₚ) mit einer die Anschlüsse des Speicherkondensators (C₁) verbindenden Reihenschaltung zweier gleichgerichteter Gleichrichterdioden (D₁, D₂) und einem mit einem Abgriff zwischen den Gleichrichterdioden einerseits und dem Versorgungswechselpotential (Uₚ) andererseits verbundenen Potentialtrennungskondensator (C₂).

2. Schaltung nach Anspruch 1, bei der der Schalttransistor (HS₁, VS₁, VS₂, S, T) einen FET-Eingang (G) aufweist.

3. Schaltung nach Anspruch 1 oder 2, bei der zwischen dem Potentialtrennungskondensator (C₂) und der Versorgungswechselspannung (Uₚ) ein erster Ohm'scher Widerstand (W) vorgesehen ist.

4. Schaltung nach Anspruch 1 oder 2, bei der ein zweiter Ohm'scher Widerstand (R₁) die Versorgungswechselspannung (Uₚ) über einen Mittenabgriff zweier in Serie geschalteter Gleichrichterdioden (D₃, D₄) zur Impedanzentkopplung mit dem Potentialtrennungskondensator (C₂) verbindet.

5. Schaltung nach Anspruch 1 oder 2, bei der ein zweiter Ohm'scher Widerstand (R₁) die Versorgungswechselspannung (Uₚ) mit dem Potentialtrennungskondensator (C₂) verbindet, wobei an die Verbindung zwischen dem zweiten Ohm'schen Widerstand (R₁) und dem Potentialtrennungskondensator (C₂) eine Z-Diode (D₅) zur Potentialklemmung angeschlossen ist.

6. Schaltung nach einem der vorstehenden Ansprüche, die für eine Lampe als Last (L) ausgelegt ist.

7. Schaltung nach Anspruch 6, die für eine Hochdruckentladungslampe als Last (L) ausgelegt ist.

8. Schaltung nach Anspruch 7, bei der der Schalttransistor (VS₁, VS₂) Teil einer die Hochdruckentladungslampe (L) beinhaltenden Vollbrückenschaltung (VS₁ - VS₄) ist.

9. Schaltung nach einem der vorstehenden Ansprüche, bei der der Schalttransistor (T, S) Teil einer Tiefsetzsteller-Schaltung ist.

10. Schaltung nach einem der vorstehenden Ansprüche, bei der parallel zu der Reihenschaltung der Gleichrichterdioden (D₁, D₂) und parallel zu den Anschlüssen des Speicherkondensators (C₁) ein spannungsbegrenzendes Element (D₆) geschaltet ist.
